# EUROPEAN PATENT APPLICATION

(11) **EP 4 297 082 A1**
(43) Date of publication of application: **27.12.2023**
(21) Application number: 22180787.8
(22) Date of filing: 23.06.2022
(51) Int. Cl.: H01L 23/495, H01L 23/552, H01L 23/31

(54) **SEMICONDUCTOR PACKAGE**

(71) Applicant: Infineon Technologies Austria AG, 9500 Villach (AT)
(72) Inventor: YUFEREV, Sergey, 9500 Villach (AT)
(74) Representative: JENSEN & SON

(57) **Abstract**

In an embodiment, a semiconductor package (10, 10', 10", 10‴, 100) comprises a semiconductor die (11) having a first surface (24), a second surface (25) opposing the first surface (24), a first contact pad (26) on the first surface (24) and a second contact pad (27) on the second surface (26), a die pad (13) and at least one lead (14) spaced apart from the die pad (13), wherein the first contact pad (26) of the semiconductor die (11) is mounted on the die pad (13) and the second contact pad (27) is electrically connected to the at least one lead (14) by a connector (15), a mold compound (16) covering the semiconductor die (11), the connector (15) and an upper surface (28) of the die pad (13) and of the at least one lead (14) and a metallic member (17) which is inductively coupled to the connector (15) and which is electrically resistively insulated from the connector (15). The metallic member (17) comprises a web portion (34) arranged above the second surface (26) of the semiconductor die (11) and at least one peripheral rim portion (35) that extends from the web portion (34) in a direction towards the first surface (24) of the semiconductor die (11).

## Description

### BACKGROUND

A semiconductor device such as a power transistor device is typically provided in a package. The package may include a substrate or a leadframe which includes outer contacts which are used to mount the package on a redistribution board such as a printed circuit board. The package also includes internal electrical connections from the semiconductor device to the substrate or leadframe and a housing which may include a plastic molding compound which covers the semiconductor device and the internal electrical connections. Common transistor devices for power applications include silicon-based CoolMOS^{®}, silicon-based Power MOSFETs, silicon-based Insulated Gate Bipolar Transistors (IGBTs), silicon carbide (SiC) power devices and Group III-N semiconductor devices, such as gallium nitride (GaN) devices,

US 2004/104489 A1 discloses a source mounted semiconductor device package for high frequency applications. The semiconductor package includes a semiconductor die having first and second opposing major surfaces, first and second major electrodes disposed on respective major surfaces and a control electrode disposed on the second major surface. In high frequency applications, the skin effect phenomenon causes an increase in package resistance. In order to reduce the package resistance, a thin metal clip is provided, which is electrically connected to the first major electrode of the die and which has a relatively large surface area,

Semiconductor packages which are suitable for medium frequency applications are desirable.

### SUMMARY

According to the invention, a semiconductor package is provided that comprises a semiconductor die having a first surface, a second surface opposing the first surface, a first contact pad on the first surface and a second contact pad on the second surface; a die pad and at least one lead spaced apart from the die pad. The first contact pad of the semiconductor die is mounted on the die pad and the second contact pad is electrically connected to the at least one lead by a connector. A mold compound covering the semiconductor die, the connector and an upper surface of the die pad and an upper surface of at least one lead. The semiconductor package further comprises a metallic member which is inductively coupled to the connector and which is electrically resistively insulated from the connector. The metallic member comprises a web portion that is arranged above the second surface of the semiconductor die and at least one peripheral rim portion that extends from the web portion in a direction towards the first surface of the semiconductor die.

The metallic member is provided as part of the semiconductor package and may be integrated into the semiconductor package, for example molded into the mold compound. Since the metallic member is inductively coupled to the connector, but electrically resistively insulated from the connector, there is no physical connection between the metallic member and other metallic portions of the package, such as the connector, die pad, leads, metallization structure providing the contact pads on the semiconductor die, or further internal electrical connections, e.g. bond wires.

During medium frequency operation of the semiconductor die, that is operation of the semiconductor die in a frequency range of 300 kHz to 3 MHz, the skin effect in the connector leads to concentration of electric current near the connector surface and a reduction of the effective cross section area, i.e. the cross-sectional area of the connector in which the current flows. In addition, inductive coupling between currents in the connector and other parts of the package such as the leadframe and the metallization of the semiconductor die, causes proximity effects resulting concentration of current on the inner side of the connector. Eddy currents, that are induced in the die pad and leads and also in the die metallization, increase power losses in these parts.

These parasitic electromagnetic effects are mitigated by the use of the metallic member which is used to reduce resistance of semiconductor devices in the medium frequency range. The medium frequency range is defined herein as 300 kHz to 3 MHz.

Due to the lack of an electrically resistive connection between the metallic member and other electrically conductive parts of the package, eddy currents are induced in the metallic member by AC source currents flowing in the connector. The eddy currents in the metallic member cause redistribution of current in the connector and make the current flow more homogeneous due to the electromagnetic induction phenomenon. This leads to a reduction of the power losses and overall resistance of the package. Thus, the package is suitable for medium frequency applications.

The peripheral rim portion extends from a position that is vertically adjacent the second surface of the semiconductor die towards the opposing first surface of the semiconductor die such that the peripheral rim portion of the metallic member is arranged laterally adjacent and spaced apart from a side face of the semiconductor die that extends between the first and second surfaces. The first and second surfaces are major surfaces, each having a larger area than the side faces.

The web portion has a lower surface that faces towards the semiconductor die and an upper surface that opposes the lower surface. The peripheral rim portion can be considered to extend from the lower surface and away from the upper surface. The peripheral rim portion may extend substantially perpendicularly from the web portion at the periphery of the web portion. In some embodiments, the peripheral rim portion extends from a lower surface of the web portion at an angle of between 90° and 175° to the lower surface.

In some embodiments, the web portion is substantially planar and has two or more side faces that are substantially perpendicular to one another. For example, the web portion may be square or rectangular in plan view. The lower and upper surface may be square or rectangular in plan view. In some embodiments, the web portion may have a polygonal shape in plan view, whereby in some embodiments two or three sides of the polygon are substantially perpendicular to one another. For example, the web portion may be considered to have a square or rectangular shape with a corner removed. A peripheral rim portion may extend from one side, two adjacent sides, three adjacent sides or two opposing sides from the web portion.

The semiconductor die includes a semiconductor device, which in some embodiments is a transistor device. In some embodiments, the transistor device is a MOSFET (Metal Oxide Semiconductor Field Effect Transistor) device, an insulated gate bipolar transistor (IGBT) device or a Bipolar Junction Transistor (BJT). The transistor device may be a vertical transistor device, i.e. have a drift path that extends substantially perpendicularly to the major surfaces of the transistor device.

In some embodiments, the semiconductor package includes two or more semiconductor dies. Each die may include a transistor device for example. The semiconductor dies may be electrically connected to one another.

In some embodiments, the metallic member is electrically floating.

In some embodiments, the metallic member is electrically resistively insulated from the connector by a portion of the mold compound. The mold compound is formed of electrically insulating material, e.g. an epoxy resin.

The die pad and the leads may be provided by a leadframe. In some embodiments, a further lead may extend from the die pad. Each lead may provide an outer contact area of the semiconductor package. In some embodiments, a lower surface of the die pad is exposed from the mold compound and provides an outer contact area. In other embodiments, the lower surface of the die pad is covered by the mold compound. The areas of the leads forming the outer contact areas of the semiconductor package are uncovered by the mold compound.

As the peripheral rim portion extends in a direction towards the first surface of the semiconductor die, it also extends towards the leadframe of the package. In embodiments in which the metallic member is electrically floating, the peripheral rim portion may have a height such that it is shorter than the distance between the lower surface of the web portion of the metallic member and the lower surface of the leadframe. In these embodiments, the distal end of the peripheral rim portion is arranged laterally adjacent the headframe.

In some embodiments, the peripheral rim portion may have a height such that it is shorter than the distance between the lower surface of the web portion and the upper surface of the leadframe. In these embodiments, the distal end of the peripheral rim portion may be arranged laterally above the leadframe or laterally adjacent the leadframe.

In some embodiments, the web portion of the metallic member is substantially planar and the at least one peripheral rim portion has a distal end that is spaced apart from an upper surface of the at least one lead on which the connector is attached.

In some embodiments, the metallic member comprises two peripheral rim portions extending from opposing lateral sides of the web portion, or three peripheral rim portions extending from three adjoining lateral sides of the web portion. The three peripheral rim portions may be integral with one another. In this embodiment, the peripheral rim portion can be considered to have a U-shape.

In some embodiments, the metallic member comprises four peripheral rim portions extending from adjoining lateral sides of the web portion. The four peripheral rims portion may be integral with one another. In this embodiment, the peripheral rim portion can be considered to be continuous and the metallic member can be considered to form a can.

In some embodiments, the metallic member partially covers the second surface of the semiconductor die. A portion of the second surface of the semiconductor die remains uncovered by the metallic member. This embodiment may be useful if bond wire connections are made to the second surface. The metallic member can be shaped and arranged such that it does not cover the bond wire connections.

In some embodiments, the metallic member entirely covers the second surface of the semiconductor die. In this embodiment, the area or lateral extent of the metallic member, in particular the web portion, is the same or greater than the area or lateral extent of the second surface of the semiconductor die. This arrangement is useful for increasing the induced eddy currents in the metallic member and increasing the effects on the reduction of the package resistance.

In some embodiments, the metallic member partially covers the connector leaving a portion of the connector uncovered or entirely covers the connector.

In some embodiments, the connector is a contact clip that has a clip web portion that is mounted on the second contact pad and a clip peripheral portion mounted on the at least one lead or on one or more of a plurality of leads that are spaced apart from the semiconductor die.

In some embodiments, the web portion of the metallic member is spaced apart from the clip web portion of the contact clip by a portion of the mold compound and the peripheral rim portion of the metallic member is spaced apart from the clip peripheral rim portion of the contact clip by a portion of the mold compound. This arrangement is useful as eddy currents are induced in the peripheral rim portion of the metallic member by AC currents flowing the peripheral rim portion of the contact clip so that the current flow in the peripheral rim portion of the contact clip in addition to in the web portion is caused to be more uniform.

In some embodiments, the thickness of the mold compound between a lower surface of the metallic member and an upper surface of the connector is D and 10 µm ≤ D ≤ 200 µm, or 10 µm ≤ D ≤ 100 µm or 20 µm ≤ D ≤ 50 µm and/or the metallic member has a thickness H and at a predetermined target frequency of operation of the semiconductor die has a skin depth δ, wherein 1.5 δ ≤ H ≤ 2.2 δ. That is one or both of the parameters of D and H may be optimised for the package. In some embodiments, D is the minimum thickness of the mold compound between a lower surface of the metallic member and an upper surface of the connector.

In some embodiments, the semiconductor die comprises a transistor device, the first contact pad is a source pad and the second contact pad is a drain pad. In some embodiments, the source pad is mounted on and electrically connected to the die pad and the connector is mounted on the drain pad such that the drain pad is electrically connected to the at least one lead by the connector. This arrangement of the transistor device is commonly called source down.

In some embodiments, the first surface of the semiconductor die further comprises a gate pad that is mounted on a gate lead that is spaced apart from the die pad. In this arrangement, the semiconductor die extends between the die pad and the gate lead. The gate pad can be considered to face down in this embodiment.

In some embodiments, the semiconductor die comprises a transistor device, the first contact pad is a drain pad and the second contact pad is a source pad. In some embodiments, the drain pad is mounted on and electrically connected to the die pad and the connector is mounted on the source pad such that the source pad is electrically connected to the at least one lead by the connector. This arrangement is commonly called drain down or source up.

In some embodiments, the first surface of the semiconductor die further comprises a gate pad that is electrically connected to a gate lead that is spaced apart from the die pad by a gate connector such as a bond wire. The gate pad can be considered to face up in this embodiment.

The transistor device may be a power transistor device for switching a load and which has a charge compensation structure. The transistor device may be a vertical transistor device with a drift path that extends substantially perpendicularly to the first surface of the semiconductor die. In some embodiments, the vertical transistor device is a MOSFET (Metal Oxide Semiconductor Field Effect Transistor) device, an insulated gate bipolar transistor (IGBT) device or a Bipolar Junction Transistor (BJT).

According to the invention, a semiconductor package is provided that comprises a first transistor device mounted on a first die pad, a second transistor device mounted on a second die pad. The second transistor device electrically coupled to the first transistor device by a connector to form a half-bridge circuit. The connector is electrically coupled to at least one lead that is spaced apart from the first and second die pads. The semiconductor package further comprises a gate driver device, a mold compound covering the first transistor device, the second transistor device, the gate driver device, the connector and an upper surface of the first and second die pads and the at least one lead and a metallic member. The metallic member comprises a substantially planar web portion that is arranged above at least a part of the upper surface of the connector. The metallic member is inductively coupled to the connector and is electrically resistively insulated from the connector by the mold compound.

This semiconductor package provides a power stage including a half bridge circuit and gate driver device for the half bridge circuit. In other embodiments, the gate driver circuit device is omitted so that the semiconductor package provides a half bridge circuit only. This package may be used for circuits including an external gate driver circuit.

In some embodiments, the connector electrically connects the first and second transistor devices.

In some embodiments, the first transistor device forms the low side switch of the half bridge circuit and the second transistor device provides the high side switch of the half bridge circuit. In some embodiments, the connector electrically connects the first and second transistor devices and provides the output node of the half bridge circuit.

In some embodiments, the first transistor device comprises a first surface, a second surface opposing the first surface, a first contact pad on the first surface and a second contact pad on the second surface. In some embodiments, the first contact pad is a source pad and the second contact pad is a drain pad, the source pad is mounted on and electrically connected to the first die pad and the connector is mounted on the drain pad such that the drain pad is electrically connected to the at least one lead by the connector.

In some embodiments, the second transistor device comprises a first surface, a second surface opposing the first surface, a first contact pad on the first surface and a second contact pad on the second surface. In some embodiments, the first contact pad is a source pad and the second contact pad is a drain pad, the drain pad is mounted on and electrically connected to the second die pad and the connector is mounted on the source pad such that the source pad is electrically connected to the at least one lead by the connector. The connector electrically connects the source pad of the second transistor device to the drain pad of the first transistor device and to the at least one lead. The at least one lead provides the output contact area of the semiconductor package.

In some embodiments, the first surface of the first transistor device further comprises a gate pad that is mounted on a gate lead that is spaced apart from the die pad.

In some embodiments, the first surface of the second transistor device further comprises a gate pad that is electrically connected to a gate lead that is spaced apart from the die pad by a bond wire.

In some embodiments, the gate driver device is mounted on a third die pad that is spaced apart from the first and second die pads. In some embodiments, the gate driver device is mounted on the first die pad. This embodiment may be used if the first die pad is at ground potential, for example

In some embodiments, the metallic member entirely covers the first transistor device and partially covers the second transistor device and the gate driver device is uncovered by the metallic member. In some embodiments, the metallic member entirely covers the first transistor device and the second transistor device and the gate driver device remain uncovered by the metallic member. These embodiments may be useful if bond wire connections are made to the upwardly facing surfaces of the second transistor device and the gate driver device. The metallic member can be shaped and arranged such that it does not cover the pads for the bond wire connections and the bond wire connections.

In some embodiments, the connector is a contact clip that has a clip web portion that is mounted on the second contact pad and a clip peripheral portion mounted on the at least one lead or on one or more of a plurality of leads that are spaced apart from the semiconductor die.

The die pad and the leads may be provided by a leadframe. In some embodiments, a lead may extend from the die pad. Each lead may provide an outer contact area of the semiconductor package. In some embodiments, a lower surface of the die pad is exposed from the mold compound and provides an outer contact area. In other embodiments, the lower surface of the die pad is covered by the mold compound. The areas of the leads forming outer contact areas of the semiconductor package are uncovered by the mold compound.

As the peripheral rim portion of the metallic member extends in a direction towards the first surface of the first transistor device, it also extends towards the leadframe of the package. In embodiments in which the metallic member is electrically floating, the peripheral rim portion may have a height such that it is shorter than the distance between the lower surface of the web portion of the metallic member and the lower surface of the leadframe. In these embodiments, the distal end of the peripheral rim portion is arranged laterally adjacent the headframe.

In some embodiments, the peripheral rim portion may have a height such that it is shorter than the distance between the lower surface of the web portion of the metallic member and the upper surface of the leadframe. In these embodiments, the distal end of the peripheral rim portion may be arranged laterally above the headframe or laterally adjacent the leadframe.

The metallic member is electrically resistively insulated from the connector by the mold compound. In some embodiments, the web portion of the metallic member is spaced apart from the clip web portion of the contact clip by a portion of the mold compound and the peripheral rim portion of the metallic member is spaced apart from the clip peripheral rim portion of the contact clip by a portion of the mold compound. This arrangement is useful as eddy currents are induced in the peripheral rim portion of the metallic member by AC currents flowing the peripheral rim portion of the contact clip so that the current flow in the peripheral rim portion of the contact clip in addition to in the web portion is caused to be more uniform.

In some embodiments, the metallic member further comprises at least one peripheral rim portion that extends from the web portion in a direction towards the at least one lead. In some embodiments, the peripheral rim portion is arranged laterally adjacent and spaced apart from three adjoining sides faces of the first transistor device.

In some embodiments, the thickness of the mold compound between a lower surface of the metallic member and an upper surface of the connector is D and 10 µm ≤ D ≤ 200 µm, or 10 µm ≤ D ≤ 100 µm or 20 µm ≤ D ≤ 50 µm and/or the metallic member has a thickness H and at a predetermined target frequency of operation of the semiconductor die has a skin depth δ, wherein 1.5 δ ≤ H ≤ 2.2 δ. That is one or both of the parameters of D and H may be optimised for the package. In some embodiments, D is the minimum thickness of the mold compound between a lower surface of the metallic member and an upper surface of the connector.

In some embodiments, the metallic member is electrically floating. In other embodiments, the metallic member is electrically connected to ground potential. For example, the metallic member may be connected to a conductive trace of a higher level circuit board on which the package is mounted that is at ground potential.

The first and second transistor devices may each be a power transistor device for switching a load and which has a charge compensation structure. The first and second transistor devices may each be a vertical transistor device with a drift path that extends substantially perpendicularly to the first surface of the semiconductor die. In some embodiments, the vertical transistor device is a MOSFET (Metal Oxide Semiconductor Field Effect Transistor) device, an insulated gate bipolar transistor (IGBT) device or a Bipolar Junction Transistor (BJT).

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1 includes figures 1 A and 1B, whereby figure 1A illustrates a perspective top view of a semiconductor package according to an embodiment and figure 1B a cross-sectional view of the semiconductor package of figure 1A.
Figure 2A illustrates a perspective top view of a semiconductor package according to an embodiment.
Figure 2B illustrates a perspective view of a semiconductor package according to an embodiment.
Figure 2C illustrates a cross-sectional view of the semiconductor package of figure 2A.
Figure 2D illustrates a side view of the semiconductor package of figure 2B.
Figure 2E illustrates a cross-sectional view of the semiconductor package of figure 2A mounted on a circuit board.
Figure 2F illustrates a cross-sectional view of a semiconductor package according to another embodiment which is mounted on a circuit board.
Figure 3A illustrates a top perspective view of a semiconductor package according to an embodiment.
Figure 3B illustrates a side view of the semiconductor package of figure 3A.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Increasing the operating frequency is desirable in some power electronic applications. Increasingly, power electronic devices operate in the medium frequency range of 300 kilohertz (kHz) to 3 megahertz (MHz). In this operating frequency range, skin and proximity effects start to play a role in increasing the device resistance. For example, the resistance of packages of discrete devices employing leadframe technology can increase by 3 to 3.5 times at 1MHz and up to 5 times at 2MHz compared to DC values.

During DC and low frequency operation, that is operation of a device, such as a transistor device, at frequencies of less than 300 kHz, the characteristic skin depth δ in the metallic parts of the package, such as a leadframe or clip, remains larger than the characteristic thickness of these parts which is typically at least 100 µm or at least 200 µm.

For a package including a clip to electrically connect a contact pad of a transistor device to a lead in which the transistor device operates at a frequency within the medium frequency range of 300kHz to 3 MHz, simulations show that for a typical thickness of 100 µm the skin effect in the clip leads to concentration of electric current near the clip surface and a reduction of the effective cross section area, i.e. the cross-sectional area of the clip in which the current flows. In addition, inductive coupling between currents in the clip and other parts of the package such as the leadframe and the metallization of the semiconductor die, causes proximity effects resulting concentration of current on the inner side of the clip. Eddy currents, induced in the leadframe and chip metallization, increase power losses in these parts.

It is proposed to mitigate parasitic electromagnetic effects and reduce resistance of semiconductor devices in medium frequency range by the use of a semiconductor package including one or more additional metallic members or electrodes which may be called an enhancement electrode.

The additional electrode is located near main current-carrying electrodes but without an electrical connection, i.e. a resistive connection, to them. Due to the lack of an electrically resistive connection, only eddy currents induced by AC source currents flowing in main electrodes may flow in the enhancement electrode. The eddy currents in enhancement electrodes cause redistribution of current in main electrodes, e.g. the clip, and make current flow more homogeneous due to the electromagnetic induction phenomenon. This leads to a reduction of the power losses and overall resistance of the system.

The resistance and inductance of the semiconductor device in medium frequency range, from 300 kHz and up to 3 MHz, is reduced by the use of additional conducting plates (enhancement electrodes), located close to the device, which may be integrated into the semiconductor package. Enhancement electrodes are isolated from main current flowing in the device. At medium frequencies currents flowing through the device induce eddy currents the enhancement electrodes. These eddy currents have reverse inductive effect on the source currents in the device causing their redistribution and mitigation of proximity effects in the device.

According to simulation results, use of a "floating" enhancement electrode enables reduction of the package resistance by up to 30% in the medium frequency range of 300 kHz to 3 MHz. For example, device resistance can be reduced by 5% and 14% at 1MHz and 2MHz, respectively. At 1MHz, the resistance of the package with an enhancement electrode increases by 2.5 times only whereas the comparison package without the additional enhancement electrode increases by 3.3 times). At 2 MHz increases of resistance of enhanced and original packages are 3.6 and 4.9 times, respectively.

According to simulation results, use of a "grounded" enhancement electrode enables reduction of the package resistance by up to 40% in medium frequency range of 300 kHz to 3 MHz. For example, device resistance can be reduced by 24% and 30% at 1MHz and 2MHz, respectively. In addition, the presence of the "grounded" enhancement electrode enables power losses in the user's circuit board such as a printed circuit board (PCB) to be reduced. At 1MHz, the resistance of the package with the enhancement electrode increases by 2 times whereas that of the comparison package without an enhancement electrode increases by 3.3 times. At 2 MHz, increases of resistance of the packages with and without an enhancement electrode are 3 and 4.9 times, respectively.

According to the invention, the enhancement electrode is integrated into semiconductor package, for example molded into the mold compound providing the package housing.

The parameters are thickness (H) of the enhancement plate and minimum distance (D) between the package and enhancement plate may be optimized.

The theoretically optimal plate thickness is double the skin depths at a target frequency. For example, the skin depth δ in copper at 2 MHz is 46um. Therefore, the optimal thickness of the plate is 100um. If H < 2 δ (92um), then eddy currents in the plate will be larger. It will increase their effect on current distribution in the package. At the same time, it will increase power losses in the plate. Total resistance will increase, but slowly. Further increase of the plate thickness (H > 2 δ) has been found to not lead to reduction of the package and device resistance.

According to electromagnetic theory, the strongest effect of eddy currents in enhancement plate of source current in the package is achieved at shortest distance between plate and package. Increase of the distance weakens the effect. At the same time, it reduces power losses in the plate and the total resistance slowly increases. For example, application of the enhancement plate is still efficient even by increasing D by 5 times (from 20um to 100um).

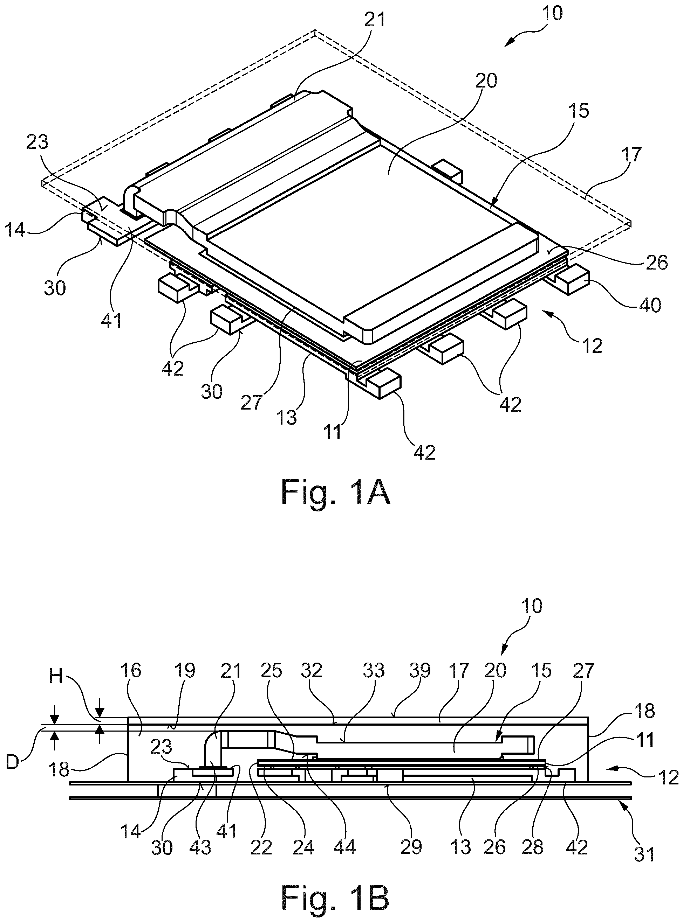

Figure 1 includes figures 1A and 1B, whereby Figure 1A illustrates a perspective top view and figure 1B a cross-sectional view of a semiconductor package 10 according to an embodiment. The semiconductor package 10 comprises a semiconductor die 11 and a leadframe 12 which comprises a die pad 13 and at least one lead 14. The semiconductor die 12 is electrically connected to at least one of the leads 14 by an electrically conductive connector 15. The semiconductor package 10 further comprises a mold compound 16 and a metallic member 17. The metallic member 17 is arranged on the mold compound 16. The metallic member 17 is inductively coupled to the connector 15 but is at the same time electrically resistively insulated from the connector 15. The mold compound 16 covers the semiconductor die 12 and is arranged between the connector 15 and the metallic member 17 and is used to electrically resistively insulate the metallic member 17 from the connector 15. The mold compound 16 is not shown in figure 1A.

The die pad 13 and the lead 14 may be substantially coplanar. In some embodiments, the lower surfaces 29, 30 of the die pad 13 and leads 14, respectively, are substantially coplanar and exposed from the mold compound 16 and form the outer contact surfaces of the semiconductor package 10. These outer contact surfaces may be used to mount the package 10 onto a higher level circuit board 31 as is illustrated in the cross-sectional view of figure 1B.

In some embodiments, and as illustrated in figure 1, the metallic member 17 is substantially planar and may have the form of a planar sheet or plate. In some embodiments, the lateral extent of the metallic member 17 is substantially the same as the lateral extent of the mold compound 16 such that the metallic member 17 extends between the side faces of the mold compound 16 which define the side faces 18 of the semiconductor package 10. In the embodiment illustrated in figure 1, the metallic member 17 has a lateral extent such that it covers the entire lateral extent of the connector 15 and the entire lateral extent of the semiconductor die 11. In some embodiments, the metallic member 17 is arranged on the upper surface 19 of the mold compound 16 and may be attached to the mold compound 16 by an additional adhesive layer or may be in direct contact with the mold compound 16, for example molded into the mold compound 16. The upper surface 39 of the metallic member 17 is exposed from the mold compound 16.

In this embodiment, the metallic member 17 is electrically floating as it is not physically connected to any further electrically conductive part of either the semiconductor package 10, e.g. the connector 15, die pad 13 or one of the leads 14, or to the circuit board 31. During operation of the semiconductor die 11, in particular in the medium frequency range of 300 kHz to 3 MHz, the alternating current flow in the connector 15 causes the current to concentrate at the surfaces of the connector 15 due to the skin effect. The alternating current flow in the connector 15 also induces eddy currents in the metallic member 17 as it is electrically conductive and inductively coupled to the connector 15. These induced eddy currents in the metallic member 17 in turn affect the current distribution in the connector 15 causing the current flow in the connector 15 to be more homogeneous and uniform. This in turn reduces power losses and the package resistance. The metallic member 17 is, therefore, used as a type of enhancement electrode in the package 10.

The semiconductor die 11 has a first surface 24 and the second surface 25 opposing the first surface 24. The connector 15 may have the form of a contact clip and have a clip web portion 20 which is substantially planar and arranged on the semiconductor die 11 and a peripheral rim portion 21 which extends beyond one side face 22 of the semiconductor die 11 and in a direction towards the opposing first side 14 of the semiconductor die 111 and towards the leadframe 12. The peripheral rim portion 21 is connected to an upper surface 23 of the at least one lead 14 in order to electrically connect the second surface 25 of the semiconductor die to the at least one lead 14. In other non-illustrated embodiments, the connector 15 has the form of one or mor bond wires or a metallic ribbon.

In some embodiments, the semiconductor die 11 has a first contact 26 on the first surface 24 and second contact pad 27 on the second surface 25. The first contact pad 26 of the semiconductor die 11 is mounted on the die pad 13, in particular, on the upper surface 28 of the die pad 13 and the second contact pad 27 is electrically connected to the at least one lead 14 by the connector 15. The first contact pad 16 may be mounted on and electrically connected to the upper surface 28 of the die pad 13 by a solder connection such as soft solder and the connector 15 may be mounted on and electrically connected to the second contact pad 27 and to the upper surface 23 of the lead 14 by a solder connection such as soft solder.

In some embodiments, the semiconductor die 12 comprises a transistor device, for example a vertical transistor device. The first contact pad 26 may be the source pad and the second contact pad 27 the drain pad. In one arrangement, which is illustrated in figure 1A and 1B, the source pad 26 is electrically connected to the die pad 13 and drain pad 27 is electrically connected to the lead 14. In some embodiments, the first surface 24 of the semiconductor die 11 further comprises a gate pad which is mounted on a gate lead 40 of the package 10 which is spaced apart from the die pad 13. The semiconductor die 11 extends between the die pad 13 and the gate lead 40.

In some embodiments, the vertical transistor device is a MOSFET (Metal Oxide Semiconductor Field Effect Transistor) device, an insulated gate bipolar transistor (IGBT) device or a Bipolar Junction Transistor (BJT).

The electrodes or terminals of the transistor device are referred to herein as source, drain and gate. As used herein, these terms also encompass the functionally equivalent terminals of other types of transistor devices, such as an insulated gate bipolar transistor (IGBT). For example, as used herein, the term "source" encompasses not only a source of a MOSFET device and of a superjunction device but also an emitter of an insulator gate bipolar transistor (IGBT) device and an emitter of a Bipolar Junction Transistor (BJT) device, the term "drain" encompasses not only a drain of a MOSFET device or of a superjunction device but also a collector of an insulator gate bipolar transistor (IGBT) device and a collector of a BJT device, and the term "gate" encompasses not only a gate of a MOSFET device or of a superjunction device but also a gate of an insulator gate bipolar transistor (IGBT) device and a base of a BJT device.

The thickness of the mold compound 16 between a lower surface 32 of the metallic member 17 and an upper surface 33 of the connector 15 is D. For embodiments in which the connector 15 is not planar, the distance D is the minimum thickness between the lower surface 32 of the metallic member 17 and the upper surface 33 of the connector 15. According to electromagnetic theory, the strongest effect of eddy currents in the metallic member 17 on the source current distribution in the connector 15 is achieved at shortest distance between the metallic member 17 and the connector 15. Increasing the distance weakens the effect. However, the effects of the metallic member have been observed in simulations even if D is increased by 5 times from 20µm to 100µm In terms of manufacturing, a larger thickness may be easier to achieve reliably. The thickness D may lie in the range of 10 µm ≤ D ≤ 200 µm, or 10 µm ≤ D ≤ 100 µm or 20 µm ≤ D ≤ 50 µm.

In some embodiments, the metallic member 17 has a thickness H and at a predetermined target frequency of operation the semiconductor die, for example the predetermined target switching frequency of a transistor device, has a skin depth δ. The theoretically optimal plate thickness H is double the skin depths at a target frequency. For example, the skin depth δ in copper at 2 MHz is 46um so that the optimal thickness of the plate is 100um. If H is much less than 2 δ (92um), then eddy currents in the plate will be larger, increasing their effect on current distribution in the package. However, power losses in the plate and the total resistance will increase, but slowly. Further increase of the plate thickness (H > 2 δ) has been found to not lead to a reduction of the package and device resistance. The thickness H of the metallic member 17 can be selected such that it lies within the range of 1.5 δ ≤ H ≤ 2.2 δ for a predetermined target frequency of operation.

The metallic member 17 provides an enhancement electrode which is inductively coupled to the connector 15 but which is electrically resistively insulated from the connector 15 and is not electrically resistively connected to the connector 15 or other metallic portion of the semiconductor package 10. A metallic member 17 according to any one of the embodiments described herein may also be used in other types of packages, for example packages having different types of leads, arrangements of leads and outer contact surfaces and/or packages including a redistribution substrate in place of the leadframe. For example, the package 10 may also conform to a TO-type package, for example a TO 220 type package, whereby the leads 14 may protrude from side faces of the mold material 16 and intermediate the thickness of the side face of the mold compound. In some embodiments, the package is a surface mount device (SMD) and the leads 14 may protrude from the side faces and the lower surface of the mold compound 16.

In some embodiments, the leadframe may be replaced with a redistribution substrate typically includes electrically insulating substrate with conductive traces on the upper surface, onto which the semiconductor die 11 and connector 15 are connected, and conductive vias which extend through the electrically insulating substrate to conductive traces arranged on the lower surface of the redistribution substrate which can form the outer contact surfaces of the package.

The connector 15 may have other forms. For example, in some embodiments, the connector 15 has the form of a contact clip with a web portion 20 and two peripheral rims portions 21, one peripheral rim portion extending from each of two opposing sides of the web portion. This enables the contact area between the leads and the connector to be increased. In another example, the connector 15 has the form of a contact clip with a web portion 20 and one or more peripheral rims portions 21, and the leads 14 are integral with the peripheral rim portion 21 of the connector 15. In some embodiments, the peripheral rim region 21 of the clip does not extend substantially perpendicularly from the lower surface of the web portion 20 such that the side face 43 of the peripheral rim portion 21 that provides the thickness of the connector 15 is mounted on the lead 14 as shown in figure 1 but extends at an angle of greater than 90°. In these embodiments, the lower surface 44 of the connector 15 is mounted on the lead 14. In some embodiments, the peripheral rim portion includes a foot which extends away from and substantially parallel to the web portion and the lower surface of the foot is mounted on the lead 14.

In the embodiment illustrated in figures 1A and 1B, the leadframe 12 comprises a plurality of leads 14. The connector 15 is arranged on and electrically connected to four leads which have an arrangement which includes four separate contact surfaces 30 on the lower side of the package 10. The four contact surfaces 30 are spaced apart along one side of the lower surface of the package 10 and exposed in the lower surface of the mold compound 16. These four leads 14 are electrically connected together by a connecting region 41 which extends between the upper surfaces 28 of the leads 14. Each of the leads 14 extends protrudes laterally and downwardly from the connecting region 41. The peripheral rim portion 22 of the connector 15 is mounted on and electrically connected to the connecting portion 41. The die pad 13 also includes leads 42 which are integral with the die pad 13 and project outwardly and downwardly from the die pad 13. The lower surface 30 of the leads 42 is exposed from the mold compound 16 and provides an outer contact area of the package 10.

The leadframe 12 may be formed of copper and the mold compound 16 may be formed of an epoxy with a filler material which is typically electrically insulating. The metallic member 17 may comprise a metal or alloy, for example be formed of copper, for example a self-supporting copper plate. The connector 15 may comprise a metal or alloy, for example be formed of copper, for example be formed of a self-supporting copper plate that is formed, e.g. machined or bent to provide the desired shape, e.g. to form the peripheral rim portion 21 at the periphery of the web portion 20.

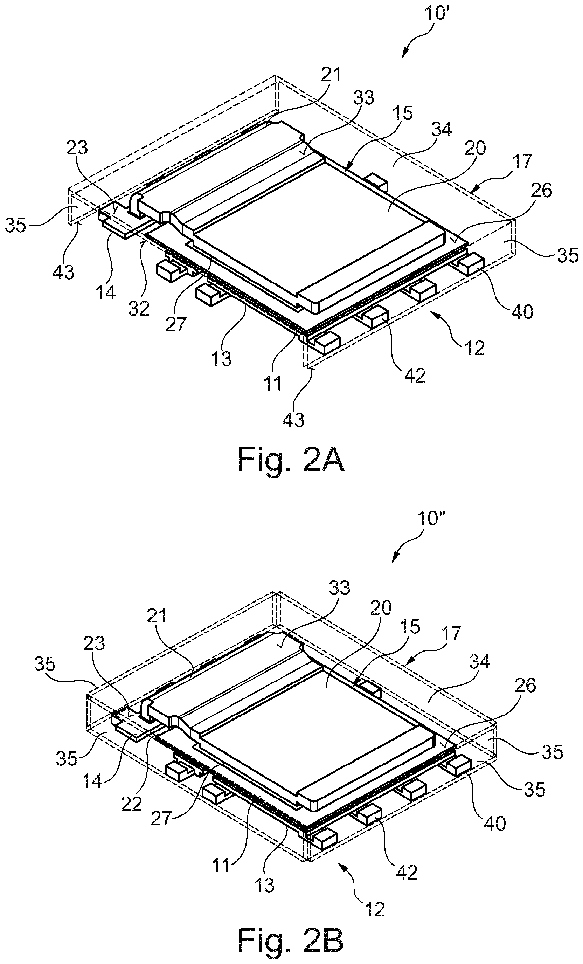

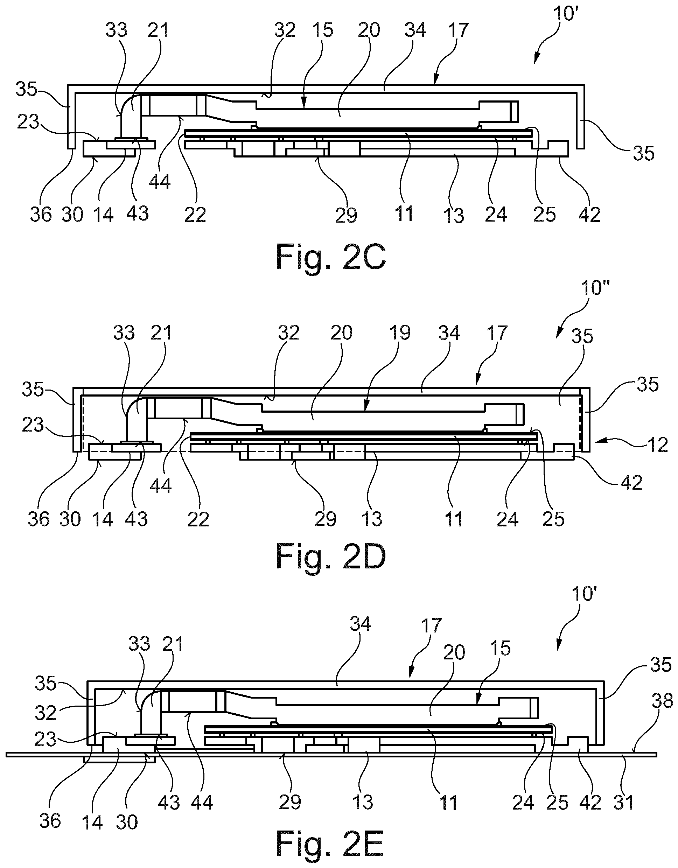

Figure 2A illustrates a perspective top view and figure 2C a cross-sectional view of a semiconductor package 10' according to another embodiment. Similar to the package 10, the semiconductor package 10' includes a semiconductor die 11 with a first contact pad 26 arranged on first side 24 which is mounted on die pad 13 of the leadframe 12 and a second contact pad 27 arranged on the second surface 25 which is electrically connected to a plurality of leads 14 which are spaced apart from the die pad 13 by a connector 15 having the form of a contact clip. The semiconductor package 10' also includes a metallic member 17. Semiconductor package 10' differs from the semiconductor package 10 illustrated in figure 1 in the shape of the metallic member 17. In this embodiment, the metallic member 17 comprises a web portion 34 which is substantially planar and two peripheral rim portions 35, one of which is arranged on each of two opposing sides of the web portion 34. The web portion 34 has a substantially rectangular form and the peripheral rim portions 35 extend from the lower surface 32 of the metallic member web portion 34 on two opposing sides. In cross-section, the metallic member 17 can be considered to have a U-shape as can also be seen in the cross-sectional view of figure 2C.

The mold compound 16 is arranged between the lower surface 32 of the web portion 34 and the upper surface 33 of the connector 15 and also between the inner side faces 37 of the two peripheral rim portions 35 and the side faces 22 of the semiconductor die 11 and the upper surface 33 of the peripheral rim portion 21 of the connector 15. Thus, the metallic member 17 is electrically resistively insulated from the semiconductor die 11, leadframe 12 and connector 15 by the intervening portions of the mold compound 16.

The primary current flow in the connector 15 is in the direction from the die pad 13 to the lead 14 and horizontal in the cross-sectional view of figure 2C. The peripheral rim portions 21 are arranged such that they are perpendicular to the primary current flow in the connector 15. The peripheral rim portion 35 of the metallic member 17 may be arranged substantially parallel to the peripheral rim portion 21 of the connector 15. This arrangement allows eddy currents to be induced in the peripheral rim portion 35 which in turn mitigate the skin effect in the peripheral rim portion 21 of the connector 15.

Figure 2B illustrates a perspective top view and figure 2D a side view of a semiconductor package 10" according to another embodiment. The semiconductor package 10" differs from that illustrated in figures 1 and 2A in the form of the metallic member 17. In this embodiment, the metallic member 17 includes a flat web portion 34 and four peripheral rim portions 35 which extend from each of the four sides of the rectangular web portion 34. The peripheral rims portions 35 may be connected to one another to form one continuous peripheral rim such that the metallic member 17 has a can shape. The side faces 22 of the semiconductor die 11 and the upper surface 33 of the peripheral rim portion 21 of the connector 15 are entirely surrounded by the peripheral rim 35 and the upper surface of the connector 15 is entirely covered by the web portion 34 of the metallic member 17. In the semiconductor packages 10', 10", the metallic member is electrically floating.

The peripheral rim portions 35 are laterally spaced apart from the leadframe 12 by intervening portions of the mold compound 16. As can be seen in the cross-sectional view of the semiconductor package 10' shown in figure 2C and the side view of the semiconductor package 10"shown in figure 2D, the peripheral rim portions 35 have a height such that they vertically overlap with the leadframe 12. The height of the peripheral rim portion between the distal end 36 and the lower surface 32 of the web portion 20 is greater than the distance between the upper surface 23 of the leads 14 and the lower surface 32 of the web portion 20 of the connector 15 and less than the distance the lower surface 30 of the leads 14 and the lower surface 32 of the web portion 20 of the connector 15. When the semiconductor package 10', 10" is mounted on a circuit board 31, as is illustrated in figure 2E, the distal end 36 of the peripheral rim portion 35 is spaced apart from and above the upper surface 38 of the circuit board 31.

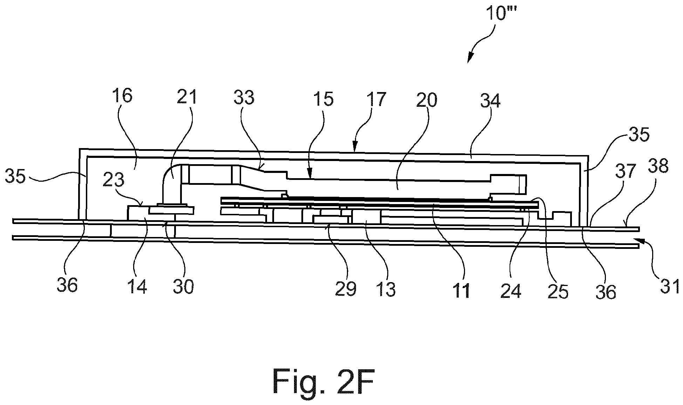

Figure 2F illustrates a cross-sectional view of a semiconductor package 10'" which differs in the arrangement of the metallic member 17 and, in particular, the height of the peripheral rim portions 35. The metallic member 17 may have one or more peripheral rim portions 35, whereby figure 2F illustrates a metallic member 17 which includes two peripheral portions 35 arranged on two opposing sides of the web portion 34. In this embodiment, the peripheral rim portion 35 has a height such that the distal end 36 is substantially coplanar with the lower surface 29, 30 of the die pad 13 and leads 14.

When the semiconductor package 10'" is mounted on circuit board 31, the distal end 36 of the peripheral rim portion 35 is in contact with the circuit board 31. This enables the metallic member 17 to be electrically connected to a conductive trace 37 arranged on the upper surface 38 of the circuit board 31, for example by a solder connection. This conductive trace 37 may be connected to a potential, for example, to ground potential. This embodiment may be used to provide an earth or grounded metallic member 17. The metallic member 17 is spaced apart from the connector 15 and the leadframe 12 of the package 10'" by portions of the mold compound 16. The lower surface 29 of the leads 14, 42 are mounted on conductive trances 37 of the circuit board 31, for example by solder connections. In some embodiments, the circuit board 31 includes a ground plane that is arranged in a layer of the circuit board other than the upper surface, for example in an internal layer or on the lower surface of the circuit board 31. The metallic member 17 may be electrically connected to this internal or lower layer by a vertical connection, for example a pin or clip.

In the embodiments illustrated in figure 1 and 2, the semiconductor package 10, 10', 10", 10'" includes a single semiconductor die 11 which typically includes a single semiconductor device but which may also include two or more semiconductor devices monolithically integrated into the semiconductor die 11. In other embodiments, the semiconductor package includes two or more separate semiconductor dies. Each die may include a transistor device, for example. The semiconductor dies may be electrically connected together to build a circuit, for example a half bridge circuit. In these embodiments, the leadframe 12 may include two or more die pads 13 which are spaced apart from one another.

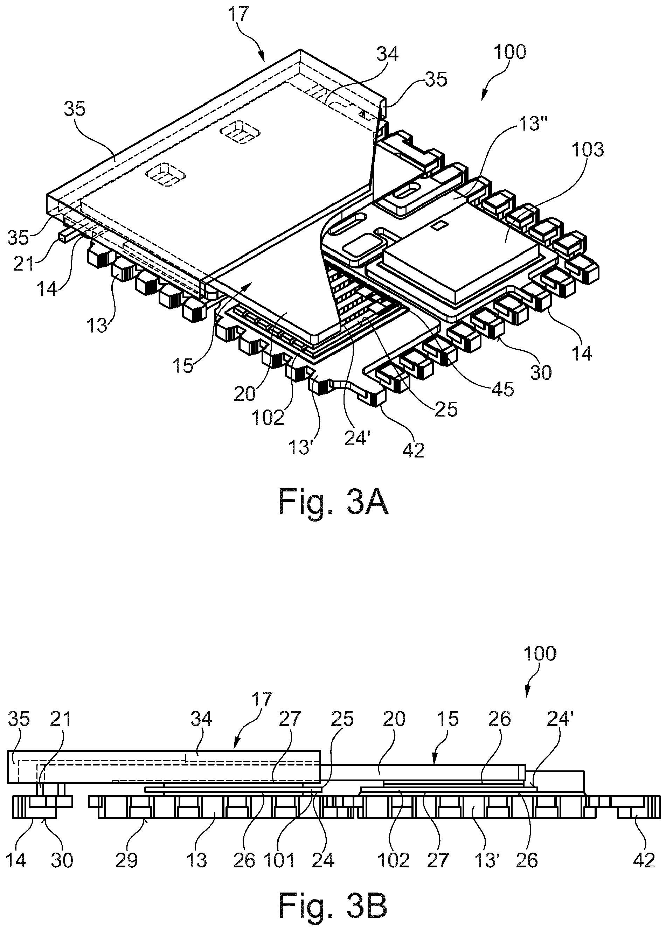

Figure 3 includes figures 3A and 3B, whereby figure 3A illustrates a top perspective view and figure 3B illustrates a side view of a semiconductor package 100 according to an embodiment. The semiconductor package 100 includes a first transistor device 101, a second transistor device 102 and a gate driver device 103, each of which is provided by a separate semiconductor die 11.

The leadframe 12 includes at least two die pads 13, 13' which are substantially coplanar and spaced apart from one another and a plurality of leads 14 that are spaced apart from the die pads 13, 13' and have lower surfaces 30 that form the outer contact areas of the package 100. The first transistor device 101 is arranged on a first die pad 13 and the second transistor device 102 is arranged on the second die pad 13'. The second transistor device 102 is electrically connected to the first transistor device 101 by a connector 15. The connector 15 is also electrically coupled to at least one lead 14 that is spaced apart from both the first and second die pad 13, 13'. Not shown in figure 3, is the mold compound 16 which covers the first transistor device 101, the second transistor device 102, the gate driver device 103 the connector 15 and the upper surface of the first and second die pads 13, 13' and the upper surface 23 of the leads 14. The semiconductor package 100 further comprises a metallic member 17 which is inductively coupled to the connector 15 and electrically insulated from the connector 15 by the mold compound 16. The metallic member 17 has a substantially planar web portion 14 which is arranged above a part of the upper surface 33 of the connector 15.

The gate driver device 103 is arranged on a third die pad 13" which is arranged in a row with the second die pad 13' and such that the second and third die pads 13' 13" are arranged on one side of the first die pad 13.

The first and second transistor devices 101, 102 may each be formed of a vertical transistor device. The first transistor device 101 may have the arrangement illustrated in figures 1 and 2 in which the source pad 26 faces downwards and is mounted on the upper surface 28 of the die pad 13, the gate pad is mounted on a separate lead 42 and the drain pad 27 on the second surface 25 which faces upwardly away from the die pad 13 is electrically connected to the connector 15. The second transistor device 102 may have the opposing arrangement such that the source pad 26' and the gate pad 45 are positioned on the upwardly facing surface 25' and the drain pad 27 on the opposing lower surface 26' is mounted on the second die pad 13'. The connector 15 is arranged on and electrically connected to the source pad 26 and the gate pad 45 remains uncovered by the connector 15.

In some embodiments, the metallic member 17 covers only a part of the connector 15 and such that a further part of the connector 15 remains uncovered by the metallic member 17. In the embodiment illustrated in figure 3, the metallic member 17 is positioned above the first transistor device 101 but not above the second transistor device 102. The metallic member 17 is arranged above the first die pad 13 but not above the second and third die pads 13', 13".

The connector 15 has a L-type shape such that it is mounted on the first transistor device 101 and the second transistor device 102 and such that the gate driver device 103 is laterally spaced apart from the connector 15 and not covered by or electrically connected to the connector 15. This arrangement may be used to enable the gate driver device 103 to be electrically connected to leads 14 of the leadframe 12 which are spaced apart from the die pads 13, 13', 13" by bond wires which require some vertical space above the gate driver device 103. The bond wires are not illustrated in figure 3.

In some embodiments, such as that illustrated in figure 3, the connector 15 is positioned on only a part of the second transistor 102 such that a portion of the upper surface 24' of the second transistor 102 remains uncovered by the connector 15. This arrangement may be used so that pads 45 on the upper surface 24' of the second transistor 102 are arranged laterally adjacent and remain uncovered by the connector 15. These pads 45, may, for example, the gate pad and/or an auxiliary pad, such as a source sense pad. Since these pads are uncovered by the connector 15, they can be more easily electrically connected to a lead 14 of the leadframe 12 by an additional connector such as a bond wire.

In some embodiments, the package 100 provides a power stage, whereby the first transistor device 101 provides the low side switch and the second transistor device 102 provides a high side switch of a half bridge circuit. The gate driver device 103 is used for switching the transistor devices 101, 102. In some embodiments, the gate driver device 103 is omitted so that the package includes a half-bridge only. In this embodiment, the package may include only two die pads.

In this embodiment, the connector 15 provides the output node of the half bridge circuit. The web portion 20 of the connector 15 is mounted on and electrically connected to the drain pad 27 of the first transistor device 101, which provides the low side switch of the half bridge circuit and to the source pad 26' of the second transistor device, which provides the high side switch of the half bridge circuit. The connector 15 comprises a peripheral rim portion 21 which extends beyond the first die pad 13 with the first transistor device 101 and which extends into a peripheral rim portion 21 which is mounted on electrically connected to one or more leads 14 which are arranged adjacent and spaced apart from the first die pad 13 on the opposing side of the first die pad 13 from the second and third die pads 13', 13".

The metallic member 17 may have the form of a substantially planar plate. In some embodiments, the metallic member 17 includes one or more peripheral rim portions 35 which extend from the lower surface 44 of the planar web portion 34 in a direction towards the leadframe 12. The peripheral rim portions 35 are therefore arranged laterally adjacent the peripheral rim 21 and two opposing sides of the web portion 20 of the connector 15. In the embodiment illustrated in figure 3, the metallic member 17 includes a peripheral rim portion extending from three adjacent substantially perpendicular sides of the web portion 20 that forms a U-shaped rim in plan view. The U-shaped peripheral rim 25 is spaced apart from and is arranged laterally adjacent three sides of the first die pad 13. The web portion 14 has a polygonal shape which is substantially rectangular shape with one corner removed to form an inclined fifth side. The web portion 20 may have a lateral shape that corresponds to the lateral shape of the underlying connector 15.

The metallic member 17 is not arranged above the third die pad 13" and not arranged above the gate driver device 103. In some embodiments, the metallic member 17 may be arranged above at least a port of the second transistor device 102, for example above some of all of the source pad 26' but not above the gate pad 45 and any auxiliary pad on the upwardly facing surface of the second transistor device.

To summarise, a semiconductor package for medium frequency applications is provided that includes a metallic member that is inductively but not resistively connected to metallic components of the package. The metallic member serves to mitigate parasitic electromagnetic effects and increased resistance of semiconductor devices caused by the alternating currents resulting from the increased frequency of operation, for example switching of a transistor device, due to the eddy currents induced in the metallic member by the alternating currents in the connector.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor package (10, 10', 10", 10‴, 100), comprising:
a semiconductor die (11) having a first surface (24), a second surface (25) opposing the first surface (24), a first contact pad (26) on the first surface (24) and a second contact pad (27) on the second surface (26);
a die pad (13) and at least one lead (14) spaced apart from the die pad (13), wherein the first contact pad (26) of the semiconductor die (11) is mounted on the die pad (13) and the second contact pad (27) is electrically connected to the at least one lead (14) by a connector (15);
a mold compound (16) covering the semiconductor die (11), the connector (15) and an upper surface (28) of the die pad (13) and of the at least one lead (14);
a metallic member (17) which is inductively coupled to the connector (15) and which is electrically resistively insulated from the connector (15);
wherein the metallic member (17) comprises a web portion (34) arranged above the second surface (26) of the semiconductor die (11) and at least one peripheral rim portion (35) that extends from the web portion (34) in a direction towards the first surface (24) of the semiconductor die (11).

2. A semiconductor package (10, 10', 10", 100) according to claim 1, wherein the metallic member (17) is electrically floating.

3. A semiconductor package (10, 10', 10", 10‴, 100) according to claim 1 or claim 2, wherein the metallic member (17) is electrically resistively insulated from the connector (15) by a portion of the mold compound (16).

4. A semiconductor package (10, 10', 10", 10‴, 100) according to any one of claims 1 to 3, wherein the web portion (34) of the metallic member (17) is substantially planar and the at least one peripheral rim portion (35) has a distal end (36) that is spaced apart from an upper surface (23) of the at least one lead (14) to which the connector (15) is attached.

5. A semiconductor package (10', 10", 10‴, 100) according to anyone of claims 1 to 3, wherein the metallic member (17) comprises two peripheral rim portions (35) extending from opposing lateral sides of the web portion (34), or three peripheral rim portions (25) extending from adjoining lateral sides of the web portion (34) or four peripheral rim portions (35) extending from adjoining lateral sides of the web portion (34).

6. A semiconductor package (10, 10', 10", 10‴, 100) according to any one of claims 1 to 5, wherein the metallic member (17) partially covers the second surface (26) of the semiconductor die (11), or entirely covers the second surface (26) of the semiconductor die (11).

7. A semiconductor package (10, 10', 10", 10‴, 100) according to any one of claims 1 to 6, wherein the metallic member (17) partially covers the connector (15) or entirely covers the connector (15).

8. A semiconductor package (10, 10', 10", 10‴, 100) according to any one of claims 1 to 7, wherein the connector (15) is a contact clip that has a clip web portion (20) mounted on the second contact pad (26) and a clip peripheral portion (21) mounted on the at least one lead (14).

9. A semiconductor package (10, 10', 10", 10‴, 100) according to claim 8, wherein the web portion (34) of the metallic member (17) is spaced apart from the clip web portion (20) of the contact clip (15) by a portion of the mold compound (16) and the peripheral rim portion (35) of the metallic member (17) is spaced apart from the clip peripheral rim portion (21) of the contact clip (15) by a portion of the mold compound (16).

10. A semiconductor package (10, 10', 10", 10‴, 100) according to any one of claims 1 to 9, wherein the thickness of the mold compound (16) between a lower surface (32) of the metallic member (17) and an upper surface (33) of the connector (15) is D and 10 µm ≤ D ≤ 200 µm, or 10 µm ≤ D ≤ 100 µm or 20 µm ≤ D ≤ 50 µm and/or wherein the metallic member (17) has a thickness H and at a predetermined target frequency of operation of the semiconductor die (11) has a skin depth δ, wherein 1.5 δ ≤ H ≤ 2.2 δ.

11. A semiconductor package (10, 10', 10", 10‴, 100) according to any one of claims 1 to 10, wherein the semiconductor die (11) comprises a transistor device, the first contact pad (25) is a source pad and the second contact pad (27) is a drain pad, wherein the source pad (26) is mounted on and electrically connected to the die pad (11) and the drain pad (27) is electrically connected to the at least one lead (14) by the connector (15).

12. A semiconductor package (10, 10', 10", 10‴, 100) according to claim 11, wherein the first surface (24) of the semiconductor die (11) further comprises a gate pad (45) that is mounted on a gate lead (42) that is spaced apart from the die pad (13).

13. A semiconductor package (100), comprising:
a first transistor device (101) mounted on a first die pad (13);
a second transistor device (102) mounted on a second die pad (13') and electrically coupled to the first transistor device (101) by a connector (15) to form a half-bridge circuit, the connector (15) being electrically coupled to at least one lead (14) that is spaced apart from the first and second die pads (13, 13');
a gate driver device (103);
a mold compound (16) covering the first transistor device (101), the second transistor device (102), the gate driver device (103), the connector (15) and an upper surface of the first and second die pads (13, 13') and the at least one lead (14);
a metallic member (17) comprising a substantially planar web portion (34) that is arranged above at least a part of the upper surface of the connector (15), wherein the metallic member (17) is inductively coupled to the connector (15) and is electrically resistively insulated from the connector (15) by the mold compound (16).

14. A semiconductor package (100) according to claim 13, wherein the first transistor device (101) forms the low side switch of the half bridge circuit and the second transistor device (102) provides the high side switch of the half bridge circuit, wherein the metallic member (17) covers the first transistor device (101) and the second transistor device (102) and the gate driver device (103) is uncovered by the metallic member (17).

15. A semiconductor package (100) according to claim 13 or claim 14, wherein the metallic member (17) further comprises at least one peripheral rim portion (35) that extends from the web portion (34) in a direction towards the at least one lead (14).
